# EUROPÄISCHE PATENTSCHRIFT

(11) **EP 1 533 189 B1**
(45) Veröffentlichungstag und Bekanntmachung des Hinweises auf die Patenterteilung: **20.01.2010**
(21) Anmeldenummer: 04024381.8
(22) Anmeldetag: 13.10.2004
(51) Int. Cl.: F16H 61/00, G01L 9/00

(54) **Steuergerät für ein Kraftfahrzeug**
Control device for motor vehicle
Dispositif de commande pour automobile

(30) Priorität: 24.11.2003 AT 18822003
(43) Veröffentlichungstag der Anmeldung: 25.05.2005
(73) Patentinhaber: Siemens AG Österreich, 1210 Wien (AT)
(72) Erfinder: Hellinger, Leopold, 3710 Ziersdorf (AT); Neumann, Gerhard, 3231 St. Margarethen (AT)
(74) Vertreter: Maier, Daniel Oliver

(56) Entgegenhaltungen:
- WO-A-02/066868
- WO-A2-00/11376
- WO-A2-02/06651
- DE-A1- 4 447 513
- DE-A1- 10 043 448
- DE-A1- 19 830 538
- DE-U1- 29 714 223
- DE-U1- 29 714 229
- US-A- 4 548 086
- US-A1- 2002 154 466

## Beschreibung

### Technisches Gebiet

Die Erfindung betrifft ein Steuergerät für ein Kraftfahrzeug, insbesondere zur Steuerung eines Getriebes, mit einer auf einer Trägerplatte in einem Gehäuse angeordneten elektronischen Steuerschaltung, wobei zur Messung des Hydraulikdrucks ein Messumformer vorhanden ist, der durch einen Druckkanal mit einer Hydraulikeinheit des Getriebes verbunden ist.

### Stand der Technik

In Serienfahrzeugen werden heute hoch entwickelte elektronische Steuergeräte zur Kontrolle vielfältiger Funktionen, beispielsweise zur Steuerung des Getriebes eingesetzt. Zur Steuerung eines automatischen Schaltgetriebes oder eines stufenlosen Getriebes verarbeitet die Getriebesteuerung Signale von mehreren Sensoren, u.a. auch Drucksensoren, die den Hydraulikdruck im Getriebe erfassen. Üblicherweise ist hierfür im Getriebegehäuse eine Öffnung vorgesehen, in welcher ein Druckkanal mit einem Messkolben ausgebildet ist. Der Messkolben wirkt auf einen Messumformer der die physikalische Größe Druck in ein elektrisches Signal umformt. Dieses Signal wird über Stecker und Verbindungsleitungen der Getriebesteuerungsplatine zugeführt.

Von Nachteil ist hierbei, dass die elektrische Verbindung zwischen Messumformer und Getriebesteuerung nicht nur technisch aufwendig, sondern auch störanfällig ist. Aus der WO 02/06651 A2 ist ein Steuergerät mit den Merkmalen des Oberbegriffes des Anspruchs 1 bekannt.

### Darstellung der Erfindung

Der vorliegenden Erfindung liegt das Problem zugrunde, ein Steuergerät zu schaffen, bei dem die Verbindung zwischen Messumformer und Steuerschaltung möglichst einfach und zuverlässig ausgeführt ist.

Die Lösung dieses Problems erfolgt durch ein Steuergerät mit den Merkmalen des Patentanspruchs 1. Auf vorteilhafte Ausgestaltungen der Erfindung nehmen die Unteransprüche Bezug.

Gemäß der Erfindung ist vorgesehen, in einem Bereich der Trägerplatte ein Federelement auszubilden, das Teil eines Messumformers ist, wobei das Federelement durch ein Verbindungsglied kraftleitend mit einer Membran verbunden ist, welche eine zum Federelement geführte Öffnung des Druckkanals dichtend umspannt.

Durch diese Konstruktion wird ein mechatronisches Modul geschaffen, bei dem die bislang erforderlichen störanfälligen elektrischen Verbindungsleitungen zwischen der Getriebesteuerung und dem örtlich entfernt liegenden Messumformer entfallen.

Für die Umformung der Durchbiegung des Federelementes in ein elektrisches Signal stehen verschiedene an sich bekannte Messprinzipien zur Auswahl, beispielsweise eine Widerstandsänderung einer Leiterstruktur.

Das erfindungsgemäße Federelement wird hergestellt , indem der Schaltungsträger, zB. eine Leiterplatte, randseitig eingeschnitten wird. Dadurch entsteht ein zungenförmiger Tragkörper auf dem ein Dehnungsmessstreifen durch Kleben angebracht werden kann. Für die Hydraulikdruckmessung kommen dadurch die bei Dehnungsmessstreifen bekannten Auswerteschaltungen zum Einsatz.

In einer bevorzugten Variante ist vorgesehen, dass am Federelement ein Permanentmagnet angebracht ist. Die Auslenkung des Federelementes kann durch einen auf der Trägerplatte befestigten magnetfeldabhängigen Sensor erfasst werden. Das elektrische Ausgangssignal des Messumformers ist wieder über eine Leiterstruktur auf der Trägerplatte der Steuerelektronik zugeführt.

Bevorzugt wird das Steuergerät als mechatronisches Anbaumodul eingesetzt, dessen Gehäuse außenseitig an einer Wand des Getriebegehäuses angebaut ist. Hierbei ist am Basisteil des Gehäuses ein hohlzylindrischer Vorsprung ausgebildet, der durch eine Öffnung des Getriebegehäuses hindurch geführt ist.

Die Fertigung ist besonders einfach, wenn die Membran, das Verbindungsglied und das Basisteil einstückig als Spritzgussteil hergestellt wird.

Ein kompakter Aufbau wird dadurch erreicht, indem die Membran im hohlzylindrischen Vorsprung etwa im Bereich der Bodenplatte d.h. nahe zur Trägerplatte angeordnet ist.

Bevorzugt werden bei der Herstellung polymere Werkstoffe. Hierbei hat es sich als vorteilhaft erwiesen, wenn die Membran im hohlzylindrischen Vorsprung angespritzt ist. Darüber hinaus kann es vorteilhaft sein, wenn die Membran aus einem polymere Werkstoff besteht, der eine Shore-Härte aufweist, die kleiner ist als eine Shore-Härte des Werkstoffs des Basisteils.

Die Abdichtung des Basisteils in der Gehäusedurchführung kann auf einfache Weise durch O-Ringe erfolgen, die in Ringnuten der äußeren Mantelfläche des hohlzylindrischen Vorsprungs ausgebildet sind.

Für die Krafteinleitung auf das Federelement ist es günstig, wenn das von der Hydraulikeinheit abgewandte Ende des Druckkanals im Wesentlichen senkrecht zur Ebene der Trägerplatte geführt ist.

Das Trägerteil ist im Bereich der Zuführung des Druckkanals durch Stützschrauben am Basisteil abgestützt. Dadurch wird verhindert, dass die Trägerplatte im Bereich der Druckeinleitung sich auswölbt und den Messwert verfälscht.

### Kurzbeschreibung der Zeichnung

Die Erfindung wird nachfolgend an Hand eines in den Zeichnungen dargestellten Ausführungsbeispiels näher erläutert. Es zeigen:
- Figur 1: das erfindungsgemäße Steuergerät, das an einer Wand eines Getriebegehäuses montiert ist in einer Seitenansicht;
- Figur 2: das erfindungsgemäße Steuergerät gemäß Figur 1 in einer Draufsicht;
- Figur 3: das erfindungsgemäße Steuergerät in einer perspektivischen Ansicht bei der das Deckelteil abgehoben ist;
- Figur 4: eine erste Variante des Messumformers in einer vergrößerten Darstellung des Details B der Figur 3;

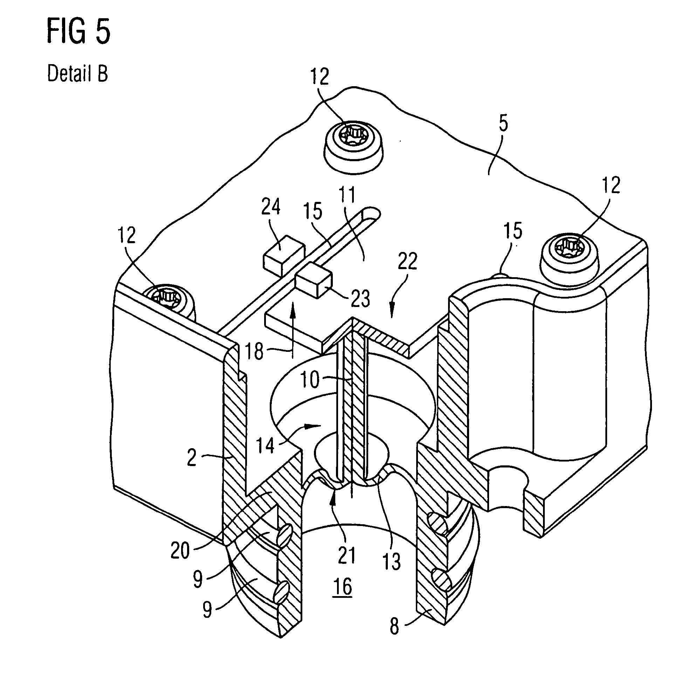

- Figur 5: eine zweiten Variante des Messumformers in einer vergrößerten Darstellung des Details B der Figur 3.

### Ausführung der Erfindung

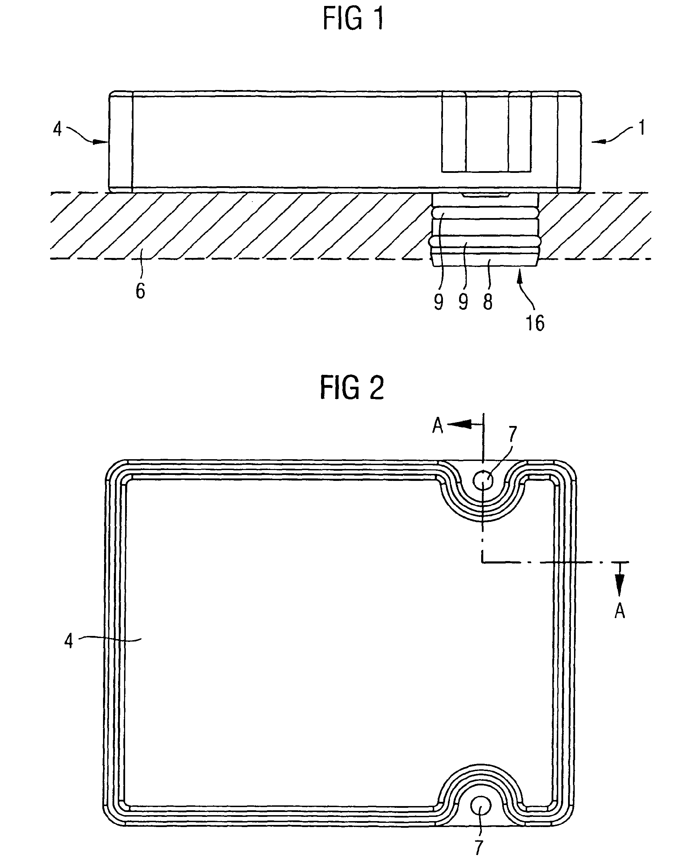

Die Figur 1 zeigt das Steuergerät 1 in einer bevorzugten Montagestellung außenseitig am Getriebegehäuse. Das Gehäuse 4 ist mittels Befestigungsschrauben 7 (Fig. 2) an der Wand 6 eines Verteilergetriebes angeschraubt. Die elektronische Steuerschaltung ist durch das Gehäuse 4 gegen Umwelteinflüsse geschützt. An einer dem Getriebe zugewandten Seite ist dein hohlzylindrischer Vorsprung 8 ausgebildet. Der hohlzylindrischen Vorsprung 8 ist durch Dichtungen 9 in der Gehäusewand 6 abgedichtet und bildet einen Teil eines Druckkanals 16, der einen Messumformer 22 (Fig. 2) mit einer nicht näher dargestellten Hydraulikeinheit des Getriebes verbindet. In der Zeichnung sind die aus dem Gehäuse herausgeführten Stecker und Anschlussleitungen, sowie an sich bekannte Druckausgleichselemente, die den Innenraum des Gehäuses mit dem Außenraum verbinden, der Übersichtlichkeit wegen nicht dargestellt.

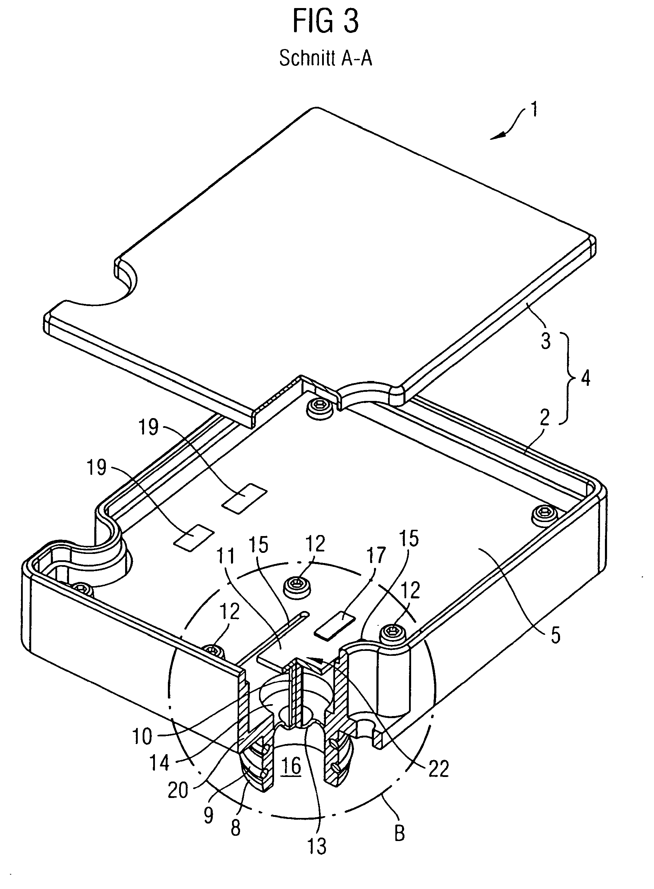

Die Figur 3 zeigt in einer perspektivischen Ansicht das Gehäuses 4 mit vom Basisteil 2 abgehobenem Deckelteil 3 in einer teilweise geschnittenen Darstellung gemäß der Linie A-A in Figur 2.

Das Basisteil 2, dessen Bodenplatte 20 direkt an der Wand 6 des Getriebegehäuses anliegt, ist aus einem Polyamid, dem ein Glasfaseranteil beigemengt ist, in Spritzgusstechnik gefertigt. Der verwendete Kunststoff ist bis 140 Grad Celsius temperaturstabil und besonders öl- und vibrationsbeständig.

Wie aus der geöffneten Darstellung der Figur 3 leicht zu sehen ist, beinhaltet das Gehäuse 4 den Messumformer 22 und eine Steuerschaltung, die durch elektronische Bauteile 19 auf einer Leiterplatte 5 angedeutet ist. Auf der Leiterplatte 5 ist, gegenüberliegend einer Zuführung des Druckkanals, ein zungenförmiges Federelement 11 ausgebildet. Das Federelement 11 wird durch etwa parallel zueinander verlaufende, randseitige Einschnitte 15 in der Trägerplatte 5 gebildet. Das Federelement 11 wirkt als Messkörper und bildet einen Teil des Messumformers 22, dessen Funktionsweise weiter unten näher beschrieben wird.

Die gehäuseseitige Öffnung 14 des Druckkanals 16 ist durch eine Membran 13 abgeschlossen. Die Membran 13 besitzt an der von der Druckbeaufschlagung abgewandten Seite ein schubstangenförmiges Verbindungsglied 10, durch welches die Membran 13 an das Federelement 11 des Schaltungsträgers 5 gekoppelt ist. Der Bereich der Leiterplatte 5, in dem der Messumformers 22 ausgebildet ist, ist durch Stützschrauben 12 am Basisteil 2 des Gehäuses 4 abgestützt.

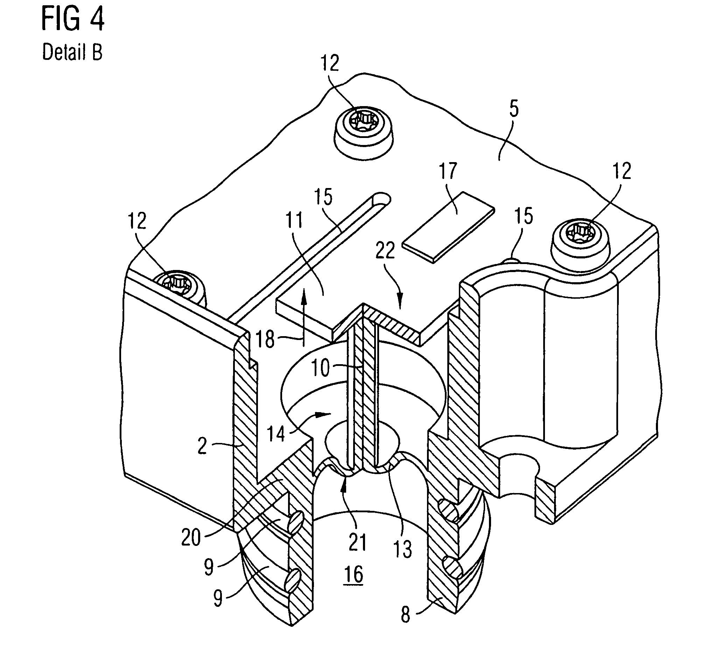

Die Funktionsweise der Hydraulikdruckmessung lässt sich am besten an Hand der Figur 4 erläutern, in der das Detail B der Figur 3 stark vergrößert dargestellt ist.

Sobald die Hydraulikeinheit des Getriebes im Hydrauliksystem des Fahrzeugs einen Druck aufbaut, gelangt dieser über den Druckkanal 16 an die Membran 13. Das stiftförmige Teil 10 stellt eine kraftleitende Verbindung zum federnden Element 11 der Trägerplatte her. Aufgrund der biegesteifen Kopplung zwischen der Membran 13 und dem Federelement 11 kommt es, je nach Größe des Hydraulikdrucks, zu einer entsprechenden Durchbiegung des Federelementes 11. Eine Erhöhung des Hydraulikdrucks verursacht eine Durchbiegung des einseitig eingespannten Balkens 11. Die Auslenkung liegt praktisch etwa unter einem Millimeter. Die Durchbiegung ist in Figur 4 durch einen Pfeil mit dem Bezugszeichen 18 angedeutet. Auf dem Federelement 11 ist ein Dehnungsmessstreifen 17 durch einen Klebstoff befestigt. Die Biegespannung bzw. Schubspannung des balkenförmigen Teils 11 wird durch diesen Dehnungsmessstreifen 17 messtechnisch erfasst, beispielsweise durch Verstimmung einer Diagonalspannung einer Brückenschaltung. Diese Messspannung wird in nicht näher dargestellten Leitern der Steuerschaltung 19 auf der Trägerplatte 5 zugeführt und direkt, beispielsweise durch einen Mikrocontroller ausgewertet. Der Mikrorechner rechnet die Durchbiegung in einen Druckwert um.

Bei der Herstellung kann der Dehnungsmessstreifen 17 durch einen SMD-Bestückungsautomat bestückt werden und anschließend im Reflowverfahren mit den anderen Bauteilen 19 der Steuerschaltung auf der Leiterplatte mitgelötet werden. Verglichen mit dem eingangs dargestellten Stand der Technik ergibt sich bei der Herstellung ein erheblicher Kostenvorteil.

Der Aufbau und die Verbindungstechnik ist durch die Integration des Messumformers 22 mit der Trägerplatt 5 bzw. der Steuerschaltung entsteht ein platzsparender Aufbau. Der kurze Übertragungsweg zwischen dem Messumformer 22 und den elektronischen Bauteilen 19 der Steuerschaltung ist hinsichtlich der Störanfälligkeit und der Zuverlässigkeit günstig. Je nach Ausführung des Dehnungsmessstreifen 17 kann dieser sowohl auf der Schub- und/oder Druckseite des Federelementes 11 angeordnet sein.

Die Membran 13 ist im dargestellten Ausführungsbeispiel aus Kunststoff gefertigt und materialeinheitlich mit dem Basisteil 2 des Gehäuses 4 in Spritzgusstechnik hergestellt. Die Membran 13 befindet sich im Druckkanal 16 etwa in der Höhe der Bodenplatte 20 des Basisgehäuseteils 2.
Alternativ zur materialeinheitlichen Ausführung kann die Membran 13 auch durch Anspritzen hergestellt sein, wobei als Werkstoff für die Membran 13 ein weicherer Kunststoff verwendet wird, als der Kunststoff das Basisteil 2.

Selbstverständlich ist es auch möglich, dass das Basisteil aus einem Metall, beispielsweise aus Alu-Druckguss, besteht und die Membran 13 als Einbauteil ausgebildet ist, das in den Druckkanal 16 eingepresst wird. Es ist auch denkbar, dass die Membran aus Metall gefertigt wird und der Betätigungsstift 10 auf der von der Druckseite 21 abgewandte Seite angeschweißt ist.

In einer Variante des Druckaufnehmers 22 ist am Federkörper 11 ein Permanentmagnet 23 befestigt. Auf der gegenüberliegenden Seite des Einschnitts 15 ist ein Magnetsenosor 24 angeordnet, der wieder die durch den Hydraulikdruck verursachte elastische Auslenkung des Federelements 11 als Veränderung des Permanentmagnetfeldes erfasst. Auch hier kann aus dem elektrischen Ausgangssignal des Magnetsensors 24 der Mikrokontroller eine Umrechnung in einen Druckwert vornehmen.

Zur Begrenzung der Auslenkung des Federelementes kann in beiden Ausführungsformen ein Anschlag vorgesehen sein. Ebenso ist es denkbar, dass zur Erhöhung der Biegesteifigkeit am Federelement 11 ein Stützblech vorgesehen wird.

### Zusammenstellung der verwendeten Bezugszeichen

- 1: Steuergerät
- 2: Basisteil
- 3: Deckelteil
- 4: Gehäuse
- 5: Trägerplatte, Schaltungsträger
- 6: Getriebegehäuses
- 7: Bohrung
- 8: hohlzylindrischer Vorsprung
- 9: O-Ring
- 10: Verbindungsglied, Zwischenstück
- 11: Federelement, planarer Federkörper
- 12: Stützschrauben
- 13: Membran
- 14: Öffnung
- 15: Einschnitt
- 16: Druckkanal
- 17: Dehnungsmessstreifen
- 18: Pfeil, Auslenkung
- 19: elektrische Bauteile
- 20: Bodenplatte
- 21: druckbeaufschlagte Oberfläche der Membran
- 22: Messumformer
- 23: Permanentmagnet
- 24: Magnetfeldsensor

## Patentansprüche

1. Steuergerät für ein Kraftfahrzeug, insbesondere zur Steuerung eines Getriebes, mit einer auf einer Trägerplatte (5) in einem Gehäuse (4) angeordneten elektronischen Steuerschaltung, wobei zur Messung des Hydraulikdrucks ein Messumformer (22) durch einen Druckkanal (16) mit einer Hydraulikeinheit des Getriebes verbunden ist, und wobei in einem Bereich der Trägerplatte (5) ein Federelement (11) ausgebildet ist, das Teil des Messumformers (22) ist, **dadurch gekennzeichnet, dass** das Federelement (11) durch ein Verbindungsglied (10) kraftleitend mit einer Membran (13) verbunden ist, welche eine zum Federelement (11) geführte Öffnung (14) des Druckkanals (16) dichtend umspannt, dass an der Trägerplatte (5) randseitige Einschnitte (15) vorhanden sind und das Federelement (11) zungenförmig ausgebildet ist.

2. Vorrichtung nach Anspruch 1 oder 2, **dadurch gekennzeichnet, dass** am Federelement (11) ein Dehnungsmessstreifen (17) angebracht ist, durch den die Auslenkung (18) des Federelementes (11) messtechnisch erfassbar ist.

3. Steuergerät nach Anspruch 1 oder 2, **dadurch gekennzeichnet, dass** am Federelement (11) ein Permanentmagnet (23) angebracht ist durch und eine Auslenkung (18) des Federelementes (11) durch einen magnetfeldabhängigen Sensor auf der Trägerplatte (5) messtechnisch erfassbar ist.

4. Steuergerät nach einem der Ansprüche 1 bis 4, **dadurch gekennzeichnet, dass** das Gehäuse (4) außenseitig an einer Wand des Getriebegehäuses (6) angeordnet ist, dass der Druckkanal (16) in einem eine Öffnung des Getriebegehäuses hindurchragenden Abschnitt durch ein am Basisteil (2) des Gehäuses (4) ausgebildeten hohlzylindrischen Vorsprung (8) gebildet ist.

5. Steuergerät nach einem der vorstehenden Ansprüche, **dadurch gekennzeichnet, dass** die Membran (13), das Verbindungsglied (10) und das Basisteil (2) einstückig als Spritzgussteil hergestellt sind.

6. Steuergerät nach einem der vorstehenden Ansprüche, **dadurch gekennzeichnet, dass** die Membran (13) im hohlzylindrischen Vorsprung (8) etwa im Bereich der Bodenplatte (20) angeordnet ist.

7. Steuergerät nach Anspruch 6 oder 7, **dadurch gekennzeichnet, dass** die Membran (13) im hohlzylindrischen Vorsprung (8) angespritzt ist und aus einem polymeren Werkstoff besteht, der eine Shore-Härte aufweist, die kleiner ist als die Shore-Härte des Werkstoffs des Basisteils (2).

8. Steuergerät nach einem der Ansprüche 5 bis 8, **dadurch gekennzeichnet, dass** an der äußeren Mantelfläche des hohlzylindrischen Vorsprungs (8) Ringnuten zur Aufnahme von ringförmigen Dichtelementen (9) vorgesehen sind.

9. Steuergerät nach einem der vorstehenden Ansprüche, **dadurch gekennzeichnet, dass** das von der Hydraulikeinheit abgewandte Ende des Druckkanals (16) im wesentlichen senkrecht zur Ebene der Trägerplatte (5) geführt ist.

10. Steuergerät nach einem der vorstehenden Ansprüche,
**dadurch gekennzeichnet, dass** das Trägerteil (5) im Bereich der Zuführung des Druckkanals (16) durch Stützschrauben (12) am Basisteil (2) abstützt ist.

## Claims

1. Control device for a motor vehicle, especially for controlling a gearbox, having an electronic control circuit disposed on a carrier plate (5) in a housing (4), wherein a measuring transducer (22) is connected to a hydraulic unit in the gearbox by a pressure channel (16) for measuring the hydraulic pressure, and wherein a spring element (11) is embodied in a region of the carrier plate (5), said spring element (11) being part of the measuring transducer (22), **characterised in that** the spring element (11) is connected to a membrane (13) by a connecting link (10) in a force conducting manner, said membrane (13) spanning and sealing an opening (14) in the pressure channel (16) for the spring element (11), notches (15) are present on the edge of the carrier plate (5) and the spring element (11) is tongue-shaped.

2. Apparatus according to claim 1, **characterised in that** an expansion measurement strip (17) is disposed on the spring element (11), through which the deflection (18) of the spring element (11) can be measured.

3. Control device according to claim 1 or 2, **characterised in that** a permanent magnet (23) is disposed on the spring element (11) and a deflection (18) of the spring element (11) can be measured by a magnetic-field-dependent sensor on the carrier plate (5).

4. Control device according to one of claims 1 to 3, **characterised in that** the housing is disposed on the exterior on a wall of the gearbox housing (6), the pressure channel (16) is formed in a section projecting through an opening in the gearbox housing by a hollow cylindrical protrusion (8) embodied on the base part (2) of the housing (4).

5. Control device according to one of the preceding claims, **characterised in that** the membrane (13), the connecting link (10) and the base part (2) are manufactured in one piece as an injection-moulded part.

6. Control device according to one of the preceding claims, **characterised in that** the membrane (13) is disposed in the hollow cylindrical protrusion (8) approximately in the region of the base plate (20).

7. Control device according to claim 5 or 6, **characterised in that** the membrane is injected in the hollow cylindrical protrusion (8) and consists of a polymer material which has a Shore hardness which is less than the Shore hardness of the material of the base part (2).

8. Control device according to one of claims 4 to 7, **characterised in that** annular grooves are provided on the external lateral surface of the hollow cylindrical protrusion (8) to accommodate annular sealing elements (9).

9. Control device according to one of the preceding claims, **characterised in that** the end of the pressure channel (16) facing away from the hydraulic unit is essentially routed perpendicular to the plane of the carrier plate (5).

10. Control device according to one of the preceding claims, **characterised in that** the carrier part (5) is supported in the region of the feed to the pressure channel (16) by support screws (12) on the base part (2).

## Revendications

1. Dispositif de commande pour un véhicule automobile, notamment pour la commande d'une transmission, comprenant un circuit électronique de commande disposé sur une plaque ( 5 ) support dans un boîtier ( 4 ), dans lequel pour la mesure de la pression hydraulique un transducteur ( 2 ) de mesure est relié à un groupe hydraulique de la transmission par un canal ( 16 ) sous pression et dans lequel dans une partie de la plaque ( 5 ) support est formé un élément ( 11 ) à ressort qui fait partie du transducteur ( 22 ) de mesure, **caractérisé en ce que** l'élément ( 11 ) à ressort est relié à une membrane ( 13 ) avec transmission de force par un élément ( 10 ) de liaison, membrane qui entoure avec étanchéité une ouverture ( 14 ), allant vers l'élément ( 11 ) à ressort, du canal ( 16 ) sous pression, **en ce que** sur la plaque ( 5 ) support sont présentes des entailles ( 15 ) du côté du bord et **en ce que** l'élément ( 11 ) à ressort est en forme de languette.

2. Dispositif suivant la revendication 1, **caractérisé en ce que** sur l'élément ( 11 ) à ressort est mise une jauge ( 17 ) de contrainte par laquelle l'excursion ( 18 ) de l'élément ( 11 ) à ressort peut être détectée en technique de mesure.

3. Dispositif suivant la revendication 1 ou 2, **caractérisé en ce que** sur l'élément ( 11 ) à ressort est mis un aimant ( 23 ) permanent et une excursion ( 18 ) de l'élément ( 11 ) à ressort peut être détectée en technique de mesure par un capteur qui dépend du champ magnétique et qui est mis sur la plaque ( 5 ) support.

4. Dispositif suivant l'une des revendications 1 à 3, **caractérisé en ce que** le boîtier ( 4 ) est disposé du côté extérieur sur une paroi du carter ( 6 ) de la transmission, **en ce que** le canal ( 16 ) sous pression est formé dans une partie passant dans une ouverture du carter de la transmission par une saillie ( 8 ) cylindrique creuse formée sur la partie ( 2 ) de base du boîtier ( 4 ).

5. Dispositif suivant l'une des revendications précédentes,
**caractérisé en ce que** la membrane ( 13 ), l'élément ( 10 ) de liaison et la partie ( 2 ) de base sont fabriquées en une seule pièce sous la forme d'une pièce moulée par injection.

6. Dispositif suivant l'une des revendications précédentes,
**caractérisé en ce que** la membrane ( 13 ) est disposée dans la saillie ( 8 ) cylindrique creuse à peu près dans la région de la plaque ( 20 ) de fond.

7. Dispositif suivant la revendication 5 ou 6, **caractérisé en ce que** la membrane ( 13 ) vient de moulage avec la saillie ( 8 ) cylindrique creuse et est en un matériau polymère qui a une dureté Shore plus petite que la dureté Shore du matériau de la partie ( 2 ) de base.

8. Dispositif suivant l'une des revendications 5 à 7, **caractérisé en ce que** sur la surface latérale extérieure de la saillie ( 8 ) cylindrique creuse sont prévues des rainures annulaires de réception d'éléments ( 9 ) annulaires d'étanchéité.

9. Dispositif suivant l'une des revendications précédentes, **caractérisé en ce que** l'extrémité du canal ( 16 ) sous pression, qui est éloignée du groupe hydraulique, est guidée sensiblement perpendiculairement au plan de la plaque ( 5 ) support.

10. Dispositif suivant l'une des revendications précédentes , **caractérisé en ce que** la partie ( 5 ) support est soutenue dans la région de l'entrée du canal ( 16 ) sous pression par des vis ( 12 ) de soutien dans la partie ( 2 ) de base.
